# EUROPEAN PATENT APPLICATION

(11) **EP 4 646 088 A2**
(43) Date of publication of application: **05.11.2025**
(21) Application number: 25170813.7
(22) Date of filing: 15.04.2025
(51) Int. Cl.: H10N 60/84, G01J 5/20

(54) **TRANSITION EDGE SENSOR**

(30) Priority: 16.04.2024 US 202463634606 P
(71) Applicant: Xanadu Quantum Technologies Inc., Toronto, Ontario M5G 2C8 (CA)
(72) Inventor: TANG, Qing Yang, Toronto, M2N 7C2 (CA); RORTAIS, Fabien Paul Laurent, 2628EC Delft (NL); COLLINS, Matthew John, Toronto, M4T 1T7 (CA)
(74) Representative: Cameron Intellectual Property Ltd

(57) **Abstract**

A transition edge sensor includes a superconducting absorber with a central absorber portion. One or more protrusions extend outward from the central absorber portion. The superconducting absorber is positioned overlying a substrate material. A thermal pathway is provided between the superconducting absorber and the substrate material to allow energy absorbed by the superconducting absorber to be dissipated. One or more heat sinks are also provided. Each heat sink is positioned to overlie a corresponding protrusion of the superconducting absorber. Each heat sink also has a portion that extends beyond the corresponding protrusion to define a separate thermal pathway from the heat sink to the substrate material.

## Description

### FIELD

This document relates generally to cryogenic detectors, and in particular to transition edge sensors.

### BACKGROUND

The following is not an admission that anything discussed below is part of the prior art or part of the common general knowledge of a person skilled in the art.

A transition edge sensor can be used to measure the energy transferred by a pulse of light radiation. Transition edge sensors can be applied as photon-number resolving (PNR) detectors capable of characterizing the number of incident photons in an incident light pulse. These PNR detectors can be applied to perform photon number resolution for multi-photon states.

Transition-edge sensor-based photon-number resolving detectors can resolve photon numbers for events containing large numbers of photons. These detectors are also capable of more than 99% system detection efficiency (the ratio of converted electrons to incident photons).

### SUMMARY

The following introduction is provided to introduce the reader to the more detailed discussion to follow. The introduction is not intended to limit or define any claimed or as yet unclaimed invention. One or more inventions may reside in any combination or sub-combination of the elements or process steps disclosed in any part of this document including its claims and figures.

In accordance with an aspect of this disclosure, there is provided a transition edge sensor. The transition edge sensor includes a superconducting absorber positioned overlying a substrate material. A thermal pathway is provided between the superconducting absorber and the substrate material to allow energy absorbed by the superconducting absorber to be dissipated. The superconducting absorber includes a central absorber portion. One or more protrusions extend outward from the central absorber portion.

One or more heat sinks are also provided. The heat sinks also overlie the substrate material. Each heat sink includes a first portion positioned to overlie a corresponding protrusion of the superconducting absorber. Each heat sink also has a second heat sink portion that extends beyond the corresponding protrusion to define a separate thermal pathway from the heat sink to the substrate material. The separate thermal pathway from the heat sink to the substrate bypasses the superconducting absorber. The heat sink(s) can thus improve the recovery rate of the superconducting absorber by providing an additional pathway for the energy absorbed by the superconducting absorber to be dissipated while also enabling the superconducting absorber to maintain a high level of energy resolution.

In accordance with this aspect, there is provided a transition edge sensor (TES) comprising: a substrate; a superconducting absorber having one or more lateral protrusions, wherein an absorber thermal pathway thermally couples the superconducting absorber to the substrate; and one or more heat sinks, wherein each of the one or more heat sinks is (1) in thermal contact with the substrate via a heat sink thermal pathway and (2) overlies a lateral protrusion of the one or more lateral protrusions.

In accordance with this aspect, there is also provided a transition edge sensor (TES) comprising: a substrate; a superconducting absorber having one or more lateral protrusions, wherein an absorber thermal pathway thermally couples the superconducting absorber to the substrate; and at least two heat sinks, each of the at least two heat sinks being partially in contact with the one or more lateral protrusions.

Each of the heat sinks can be in thermal contact with the substrate via a heat sink thermal pathway.

The TES can include at least four heat sinks.

The TES can include at least six heat sinks.

The TES can include one or more intermediary layers, where the absorber thermal pathway between the superconducting absorber and the substrate extends through the one or more intermediary layers.

The heat sink thermal pathway between each heat sink and the substrate can at least partially bypass the superconducting absorber.

Each layer of the one or more intermediary layers can include at least one of amorphous silicon, SiO₂, a backside mirror, or a dielectric material.

A subset of the one or more intermediary layers can define a distributed Bragg reflector.

At least one heat sink can include a first heat sink portion and a second heat sink portion, where the first heat sink portion overlies the corresponding lateral protrusion, and the second heat sink portion overlies solely one or more of the intermediary layers.

Each heat sink can include at least a first heat sink portion and a second heat sink portion, where for each heat sink the first heat sink portion overlies the corresponding lateral protrusion, and the second heat sink portion overlies solely one or more of the intermediary layers.

The one or more protrusions can extend outward from the superconducting absorber along a lateral direction and the second heat sink portion can extend outward from the first heat sink portion along a longitudinal direction perpendicular to the lateral direction.

The one or more protrusions can extend outward from the superconducting absorber along a lateral direction and the second heat sink portion can extend outward from the first heat sink portion along the lateral direction.

The superconducting absorber, the one or more lateral protrusions, and the second heat sink portion of each heat sink can be in direct contact with at least some of the intermediary layers and directly overlie the at least some of the intermediary layers.

An area of the second heat sink portion may be at least 5% of the area of the first heat sink portion.

An area of the first heat sink portion may be at least 5% of the area of the second heat sink portion.

An area of the first heat sink portion may be equal to or less than an area of the second heat sink portion.

The area of the first heat sink portion may be equal to or less than 50% of the area of the second heat sink portion.

The superconducting absorber can include a central portion, the lateral protrusions can extend outward from the central portion along a lateral direction, and the central portion can have a length of at least 15 µm in the lateral direction and a width of at least 15 µm in a longitudinal direction.

The superconducting absorber can include a central portion, the lateral protrusions can extend outward from the central portion along a lateral direction, and the central portion can have a length of at least 20 µm in the lateral direction and a width of at least 20 µm in a longitudinal direction.

The superconducting absorber can include a central portion, the lateral protrusions can extend outward from the central portion along a lateral direction, and the central portion can have a first width extending along a longitudinal direction perpendicular to the lateral direction; each lateral protrusion can have a second width in the longitudinal direction; and the first width is substantially greater than the second width.

The second width can be in a range of about 0.5% to about 30% of the first width.

The second width can be in a range of about 3% to about 19% of the first width.

The second width can be in a range of about 2.5% to about 10% of the first width.

The second width can be in a range of about 4% to about 11% of the first width.

The second width can be in a range of about 0.5 µm to about 3 µm.

The second width can be in a range of about 0.9 µm to about 2.2 µm.

The second width may be at most 1.2 µm.

The second width can be defined to maintain a superconducting order parameter of the superconducting absorber that exists in the absence of the lateral protrusions.

The superconducting absorber can include a central portion, the lateral protrusions can extend outward from the central portion along a lateral direction, and each heat sink can be spaced apart from the central portion by a first distance along the lateral direction.

The central portion can have a first length extending along the lateral direction and the first distance can be in a range of about 1% to about 40% of the first length.

The central portion can have a first length extending along the lateral direction and the first distance can be in a range of about 3% to about 21% of the first length.

The central portion can have a first length extending along the lateral direction and the first distance can be in a range of about 5% to about 15% of the first length.

The central portion can have a first length extending along the lateral direction and the first distance can be in a range of about 5% to about 13% of the first length.

The first distance can be in a range of about 1 µm to about 4µm.

The first distance can be in a range of about 1 µm to about 2.5 µm.

The first distance may be at most 2.5 µm.

Each heat sink can include gold.

A total volume of the heat sinks can be in a range of about 2 µm³ to about 30 µm³.

A total volume of the heat sinks can be in a range of about 5 µm³ to about 20 µm³.

A total volume of the heat sinks can be in a range of about 5 µm³ to about 15 µm³.

A total volume of the heat sinks can be in a range of about 8 µm³ to about 12 µm³.

The total volume of the heat sinks may be about 10 µm³.

The present disclosure also provides an energy sensor system comprising a transition edge sensor (TES) comprising: a substrate; a superconducting absorber having one or more lateral protrusions, wherein an absorber thermal pathway thermally couples the superconducting absorber to the substrate; and one or more heat sinks; wherein each of the one or more heat sinks is (1) in thermal contact with the substrate via a heat sink thermal pathway and (2) overlies a lateral protrusion of the one or more lateral protrusions; an inductor connected in series with the TES; and a magnetometer inductively coupled with the inductor, wherein the TES is described herein.

The energy sensor system can include at least one readout lead coupling the TES to the inductor.

The energy sensor system can be configured to measure a change in current through the TES in response to a photon being deposited on the TES.

The magnetometer can be configured to detect a change in current through the TES in response to a photon being deposited on the TES.

It will be appreciated by a person skilled in the art that an apparatus, system, or method disclosed herein may embody any one or more of the features contained herein and that the features may be used in any particular combination or sub-combination.

These and other aspects and features of various embodiments will be described in greater detail below.

### BRIEF DESCRIPTION OF THE DRAWINGS

The drawings included herewith are for illustrating various examples of articles, methods, and apparatuses of the present specification and are not intended to limit the scope of what is taught in any way. In the drawings:
FIG. 1 is a circuit diagram illustrating an example energy sensor system including a transition edge sensor;
FIG. 2 is a simplified plan view of an example transition edge sensor that may be used in the example system of FIG. 1;
FIG. 3 is a cross-section taken along lines A-A shown in FIG. 2;
FIG. 4 is a cross-section taken along lines B-B shown in FIG. 2;
FIG. 5 is a cross-section taken along lines C-C shown in FIG. 2;
FIG. 6 is a block diagram showing a simplified thermal model of the example transition edge sensor shown in FIG. 2;
FIG. 7A is a simplified plan view of another example transition edge sensor that may be used in the example system of FIG. 1; and
FIG. 7B is a simplified plan view of another example transition edge sensor that may be used in the example system of FIG. 1.

### DETAILED DESCRIPTION

Various apparatuses or processes or compositions will be described below to provide an example of the claimed subject matter. No example described below limits any claim and any claim may cover processes or apparatuses or compositions that differ from those described below. The claims are not limited to apparatuses or processes or compositions having all of the features of any one apparatus or process or composition described below or to features common to multiple or all of the apparatuses or processes or compositions described below. It is possible that an apparatus or process or composition described below is not an example of any exclusive right granted by issuance of this patent application. Any subject matter described below and for which an exclusive right is not granted by issuance of this patent application may be the subject matter of another protective instrument, for example, a continuing patent application, and the applicants, inventors, or owners do not intend to abandon, disclaim, or dedicate to the public any such subject matter by its disclosure in this document.

For simplicity and clarity of illustration, reference numerals may be repeated among the figures to indicate corresponding or analogous elements. In addition, numerous specific details are set forth in order to provide a thorough understanding of the subject matter described herein. However, it will be understood by those of ordinary skill in the art that the subject matter described herein may be practiced without these specific details. In other instances, well-known methods, procedures, and components have not been described in detail so as not to obscure the subject matter described herein. The description is not to be considered as limiting the scope of the subject matter described herein.

The terms "coupled" or "coupling" as used herein can have several different meanings depending on the context in which these terms are used. For example, the terms coupled or coupling can have a mechanical, electrical, or communicative connotation. For example, as used herein, the terms coupled or coupling can indicate that two elements or devices can be directly connected to one another or connected to one another through one or more intermediate elements or devices via an electrical element, electrical signal, or a mechanical element depending on the particular context. Furthermore, the term "communicative coupling" may be used to indicate that an element or device can electrically, optically, or wirelessly send data to another element or device as well as receive data from another element or device.

As used herein, the wording "and/or" is intended to represent an inclusive- or. That is, "X and/or Y" is intended to mean X or Y or both, for example. As a further example, "X, Y, and/or Z" is intended to mean X or Y or Z or any combination thereof.

Terms of degree such as "substantially", "about", and "approximately" as used herein mean a reasonable amount of deviation of the modified term such that the end result is not significantly changed. These terms of degree may also be construed as including a deviation of the modified term if this deviation would not negate the meaning of the term it modifies.

Any recitation of numerical ranges by endpoints herein includes all numbers and fractions subsumed within that range (e.g., 1 to 5 includes 1, 1.5, 2, 2.75, 3, 3.90, 4, and 5). It is also to be understood that all numbers and fractions thereof are presumed to be modified by the term "about" which means a variation of up to a certain amount of the number to which reference is being made if the end result is not significantly changed.

The present disclosure relates to the configuration of a transition edge sensor. A transition edge sensor is a device that can be used to measure the energy transferred by a pulse of light radiation. Transition edge sensors can also be applied as photon-number resolving (PNR) detectors capable of accurately characterizing the number of incident photons in an incident light pulse. These PNR detectors can be applied to perform photon number resolution for multi-photon states.

Transition-edge sensor-based photon-number resolving detectors can resolve photon numbers for events containing large numbers of photons. These detectors are also typically faster than conventional detectors and have more than 99% system detection efficiency (the ratio of converted electrons to incident photons).

In a transition-edge sensor, it is desirable to optimize both the recovery rate and the resolution of the sensor. Maintaining or increasing the resolution of the transition-edge sensor can increase the accuracy of the detection events. This can be particularly useful in photon-number resolving applications, to ensure that the sensor can discriminate between states having small differences in energy. Reducing the recovery rate allows the sensor to detect subsequent light pulses more quickly, facilitating real-time applications of the transition-edge sensors such as real-time photon number resolution.

Sensors capable of performing photon number resolution in real-time are desirable for many applications. Real-time photon number resolution can enable real-time heralding of an entangled multiphoton state. For example, real-time photon number resolution can play an important role in the field of quantum optics particularly in relation to the transition from Gaussian to non-Gaussian resources. The non-Gaussian resources, be it states, operations, or measurements, are essential or at least advantageous for many applications, such as quantum computation, quantum error correction, or quantum communication. The ability to discriminate between states with different photon numbers

(particularly in real-time) is useful for non-Gaussian quantum state preparation, state characterization (tomography), increasing the probability of generating non-Gaussian quantum states through multiplexing, the deterministic implementation of non-Gaussian operations using non-Gaussian ancilla states, and implementation of the KLM quantum protocol.

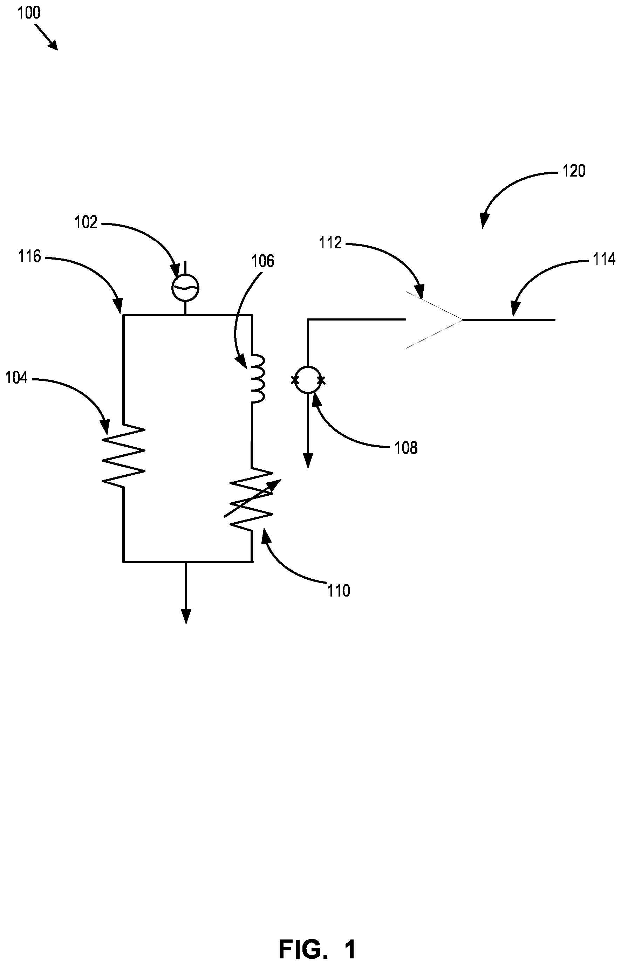

Referring now to FIG. 1, shown therein is a block diagram illustrating an example energy sensor system 100. The example energy sensor system 100 includes an energy sensing circuit 116 and a sensor output circuit 120. The energy sensing circuit 116 includes a transition edge sensor (TES) 110.

The TES 110 generally includes a superconducting absorber with a temperature-dependent electrical resistance. The absorber can be arranged to receive and absorb incident radiation (e.g., photons in a light pulse). The superconducting absorber acts as both an absorber and a thermometer to enable the energy of the incident energy to be measured.

The superconducting absorber has a transition temperature such that the absorber can be maintained at the edge of a phase transition in operation. The current source 102 can be controlled to maintain the superconducting absorber at the edge of a phase transition. As shown in FIG. 1, the bias current is driven through a resistive load (e.g., resistor 104) arranged in parallel with the TES 110. This generates a voltage-bias that maintains the TES 110 in a self-biased region.

When the TES 110 absorbs an incident light pulse (i.e., one or more photons), the temperature of the absorber is increased. This results in an increase in the resistance of the TES 110 and a corresponding drop in the current through the TES 110. The change in the current through the TES 110 can then be measured to determine the energy associated with the light pulse absorbed by TES 110.

For example, the TES 110 may be cooled near or below the transition temperature (i.e., on the order of tens or hundreds of milli-Kelvin) such that, when a current is applied to bias the TES 110, the absorber operates along its transition curve. The absorption of one or more photons causes a temperature change in the absorber of the TES 110, thereby increasing the resistivity of the TES 110 leading to a voltage drop across the TES 110. The voltage drop may be proportional to the number of photons absorbed by the TES 110.

By maintaining the absorber along its transition curve, the change in temperature can result in a relatively larger increase in resistance thereby facilitating measurement of the incident energy pulse. The voltage-bias then enables the absorber to return to its target temperature after receiving the deposition of thermal energy by way of negative electrothermal feedback. The absorber can be thermally coupled to a thermal bath to enable the energy from the incident photon(s) to be dissipated. The thermal bath can be maintained at a temperature substantially below the transition temperature to ensure that the absorber returns to its operating temperature after absorbing an incident light pulse.

As shown in FIG. 1, the system 100 includes an inductor 106 inductively coupled to the output circuit 120. The output circuit 120 can include a magnetometer inductively coupled to the inductor 106. In the example illustrated, the magnetometer is provided in the form of a SQUID array 108. Alternatively, a kinetic inductance detector may be used to measure the change in the current passing through the TES 110.

As shown, the inductor 106 is coupled in series with the TES 110. The change in current through TES 110 (due to photon absorption) thus results in a change in current through the inductor 106. This, in turn, results in a change in the flux experienced by the magnetometer (i.e., SQUID array 108). The output from the magnetometer 108 can then be output at 114 and measured. The output from the magnetometer 108 can be processed to determine the energy of the photon(s) absorbed by TES 110 (and optionally the associated photon number of the incident light pulse).

A signal processor can be electrically coupled to the system 100 (e.g., to the output 114 of output circuit 120). The signal processor is arranged to receive the electrical signal trace produced by the system 100 in response to an incident optical pulse received by TES 110.

The signal processor can be implemented using one or more processors such as a specialized or general purpose microprocessor. The processor(s) control the operation of the signal processor and in general can include any suitable processor such as a microprocessor, controller, digital signal processor, field-programmable gate array, application-specific integrated circuit, microcontroller, or other suitable computer processor that can provide sufficient processing power, depending on the desired configuration, purposes, and requirements of the system 100.

The signal processor can include the processor, a power supply, memory, and a communication module operatively coupled to the processor and to the system 100. The memory can include RAM, ROM, one or more hard drives, one or more flash drives or some other suitable data storage elements such as disk drives, etc. Optionally, the signal processor can be operatively coupled to at least one input device (e.g., a pushbutton keyboard, mouse, touchscreen, and the like), and at least one output device (e.g., a display screen).

The electrical signal trace from the system 100 can be detected and recorded using a data acquisition system (e.g., output circuit 120). The data acquisition system can be integrated into the signal processor. Alternatively, the data acquisition system may be external from, and separate to, the signal processor.

The data acquisition system can include appropriate hardware circuitry and/or software components usable to detect and record the electrical signal trace from the system 100. Optionally, the data acquisition system can include one or more amplifiers 112 to amplify the output electrical signals (i.e., voltage drop) of the TES 110. Optionally, the data acquisition system can include an analog-to-digital converter usable to digitize the electrical signal trace such that the electrical signal trace values are quantized into discrete digital quantities. Alternatively, the data acquisition system may omit an analog-to-digital converter, for instance where the electrical signal trace is analyzed in the analog domain.

The non-transitory memory of the signal processor can store machine-readable instructions executable by the one or more processors of the signal processor. The instructions stored on the non-transitory memory of the signal processor can be defined to cause the one or more processors to perform processes relating to measuring the electrical signal trace, e.g., determining a photon number associated with an electrical signal trace.

Various signal processing techniques can be used to improve the recovery rate and resolution of a transition edge sensor. For example, United States Patent Application No. 18/538,154 describes signal processing techniques that can be used to reduce the recovery time of a photon-number resolving detector. However, these techniques are limited by the physical properties of the sensor that receives the incident photon energy. Improving the design of the transition edge sensor can further enable rapid and real-time measurement of incident photon energy and photon-number resolving. In particular, it is desirable to maintain the resolution of the sensor to ensure greater sensitivity and specificity while reducing its recovery time (the time required to return the absorber to its operating temperature) to enable real-time photon number resolution for high-throughput applications.

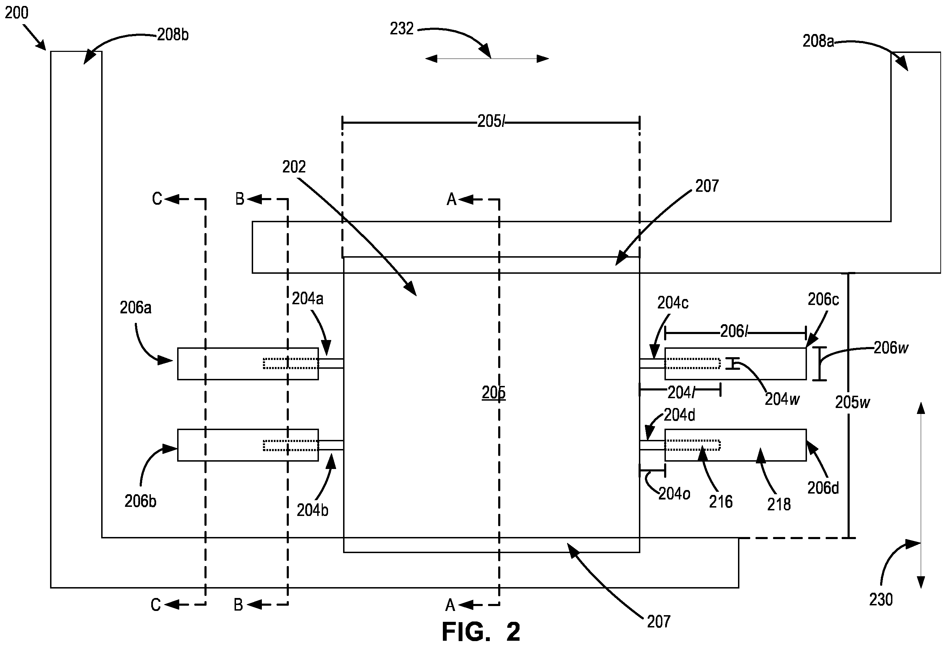

Referring now to FIGS. 2-5, shown therein is an example transition edge sensor 200. The example transition edge sensor 200 may be used within an energy sensing system, for instance as transition edge sensor 110 shown in FIG. 1. The transition edge sensor 200 generally includes a substrate 328, superconducting absorber 202 and one or more heat sinks 206.

As noted above, the absorber 202 can be thermally coupled to a thermal bath to enable the energy from the incident photon(s) to be dissipated. In the example of TES 200, the thermal bath can be provided by the substrate 328. The energy from photons incident on the absorber 202 can be dissipated to the substrate 328 to enable the absorber 202 to return to its operating temperature after measurement of the incident energy.

The superconducting absorber 202 is thermally coupled to the substrate 328 by an absorber thermal pathway. Heat generated by the absorber 202 (e.g., in response to the absorption of a photon) can be dissipated (at least partly) to the substrate 328 through the absorber thermal pathway.

The example shown in FIG. 2 includes an absorber 202 with a substantially rectangular central portion 205. This can provide a more uniform current distribution across the absorber 202. Alternatively, other shapes may be used for the central portion 205 depending on the desired application of the TES 200.

The central portion 205 is intended to receive and absorb incident pulses of light to be measured. For example, in system 100, the transition edge sensor 110 can be arranged to receive an incoming optical pulse from a light source. The light source may be provided as a component of system 100, or the light source may be separate from, and located outside of, system 100 as an independent component or a subcomponent of another system. The light source may, for example, be a pulsed photon source that is capable of generating faint laser pulses, or a resonator capable of generating squeezed light pulses or single-photon generating sources. The light source can include suitable optical components usable to generate the optical pulse.

As shown in FIG. 2, the central portion 205 has a length 205*l* extending in a lateral direction 232 and a width 205w extending in a longitudinal direction 230. In the example illustrated, the central portion 205 is a square central portion in which the length 205/ and width 205w are equal.

As shown in FIG. 2, the absorber 202 also includes overlapping sections 207. The overlapping sections 207 are in contact with leads 208. The overlapping sections 207 provide a coupling between the absorber 202 and the leads 208. The overlapping sections 207 extend from the central portion 205. The central portion 205 is exposed to enable incident radiation to be received. The overlapping sections 207 may not be exposed (e.g., obscured by the leads 208) such that incident light radiation does not contact the overlapping sections 207 directly.

The size of the central portion 205 can be defined to enable light pulses to be incident on the absorber surface (i.e., to ensure that a light source can be optically aligned to the central portion 205) while maintaining a desired heat capacity for the absorber 202.

The central portion 205 can be sized to ensure that the absorber 202 can be optically aligned to receive an incoming pulse of light. For example, the length 205/ (and width 205w) may be defined to be at least about 10 µm. For an optical fiber having a core diameter as low as about 5 µm or as low as about 10 µm, this size enables the central portion 202 to capture all of the light emitted from the optical fiber once properly aligned. Optionally, the length 205/ (and width 205w) may be at least about 12 µm or at least about 13 µm to provide tolerance for misalignment between the optical fiber and the central portion 205. In some examples, the length 205/ (and width 205w) may be at least about 15 µm.

Optionally, the length 205/ and width 205w may be at least 20 µm to provide additional tolerance for misalignment. Further optionally, the length 205/ and width 205w may be at least 30 µm to provide additional tolerance for misalignment. Optionally, the length 205/ and width 205w may be upwards of about 70 µm.

As the size of the central portion 205 increases, the heat capacity of the absorber 202 increases. This increases the decay time after photon absorption (i.e., the time required for the absorber to return to its operating temperature), thus reducing the throughput capability of the absorber 202. The increased heat capacity also reduces the sensitivity of the absorber 202 to individual photon absorption, thereby reducing the photon number resolution.

Optionally, the length 205/ (and width 205w) may be at most about 100 µm. This may provide increased tolerance for the alignment of the central portion 205 with an incoming light source without unduly impacting the heat capacity of the absorber 202.

As shown in FIG. 2, the superconducting absorber 202 includes a central portion 205 and one or more lateral protrusions 204. Each lateral protrusion 204 extends outward and away from the central portion 205. Each lateral protrusion 204 may also be referred to as a projection of the superconducting absorber 202.

In the example shown, each lateral protrusion 204 has the same dimensions (i.e., length 204/ and width 204w). Alternatively, the lateral protrusions 204 may have different dimensions (e.g., different lengths, widths, and/or depths). Optionally, protrusions 204 extending from one side of the central portion 205 may have a first set of dimensions while the protrusions extending from another side of the central portion may have a second set of dimensions that is different (e.g., different lengths of protrusions on opposite sides of the central portion 205).

Each heat sink 206 is associated with a corresponding lateral protrusion 204 of the absorber 202. The lateral protrusions 204 provide a pathway for electrons and phonons to travel between the central absorber portion 205 and the heat sinks 206. This provides an additional thermal pathway for heat energy to be dissipated to the substrate 328 through the heat sinks 206.

As shown in FIG. 2, each lateral protrusion 204 is substantially smaller than the central portion 205. The lateral protrusions 204 can be sized to provide a pathway to the heat sinks 206 while not substantially increasing the overall volume of the absorber 202. For example, the one or more lateral protrusions 204 can be configured to substantially maintain the superconducting order parameter of the superconducting absorber 202 that would exist in the absence of the lateral protrusions 204.

In the example shown in FIG. 2, each lateral protrusion extends outward from the central absorber portion by a length 204*l* in the lateral direction 232. Each lateral protrusion 204 also has a width 204w that extends in the longitudinal direction 230.

The width 204w of each protrusion 204 can be substantially less than the width 205w of the central portion 205. This may ensure that the protrusions 204 do not overly impact the size of the absorber 202. The protrusion width 204w can be in a range of about 0.5% to about 30% of the central portion width 205w. For example, the protrusion width 204w may be in a range of about 3% to about 19% of the central portion width 205w. Preferably, the protrusion width 204w may be in a range of about 2.5% to about 10% of the central portion width 205w or about 3.5% to about 9.5% of the central portion width 205w.

The width 204w of each protrusion 204 can be selected to be sufficiently large to provide a pathway for phonons to travel from the central portion 205 to the corresponding heat sink 206. The protrusion width 204w can be at least about 0.5 µm. For example, the protrusion width 204w may be at least about 0.9 µm. This can ensure that the phonons are able to travel from the central portion 205 to the corresponding heat sink 206. This can also simplify the fabrication process for the TES 200.

Optionally, the protrusion width 204w can be in a range of about 0.5 µm to about 5 µm. For example, the protrusion width 204w can be in a range of about 0.5 µm to about 3 µm. Further optionally, the protrusion width 204w can be in a range of about 0.9 µm to about 2.2 µm.

Optionally, the protrusion width 204w may be at most about 1.5 µm. Further optionally, the protrusion width 204w may be at most about 1.2 µm.

For example, the inventors have found that in some applications a protrusion width 204w of about 1.2 µm may be preferable to provide a balance between providing a phonon pathway and minimizing the volume added to the absorber 202.

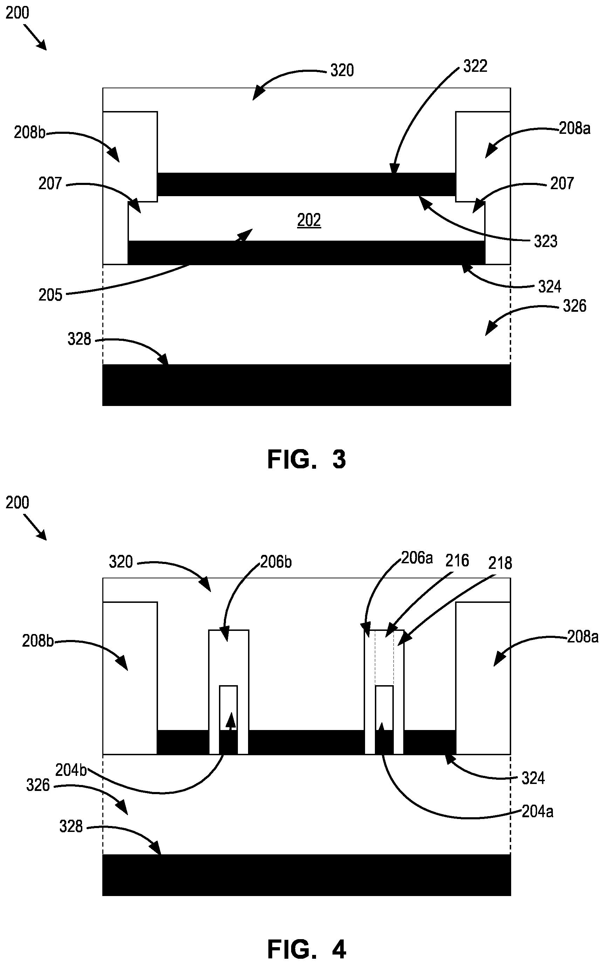

Each heat sink 206 is associated with a corresponding lateral protrusion 204 of the absorber 202. As shown in FIGS. 2 and 4, each heat sink 206 is arranged in direct contact with the corresponding lateral protrusion 204. Each heat sink 206 is arranged to at least partially overlie the corresponding lateral protrusion 204.

Each heat sink 206 can be positioned in partial contact with the corresponding lateral protrusion 204. For example, the surfaces of the heat sink 206 immediately adjacent to the corresponding lateral protrusion 204 can be provided in direct contact with the corresponding protrusion 204.

Optionally, an intervening layer may be positioned between the heat sink 206 and the corresponding lateral protrusion 204. This may facilitate the adhesion of the heat sink material to the protrusion 204. For example, a thin layer of titanium may be deposited to enable the heat sink material to adhere to the corresponding protrusion 204.

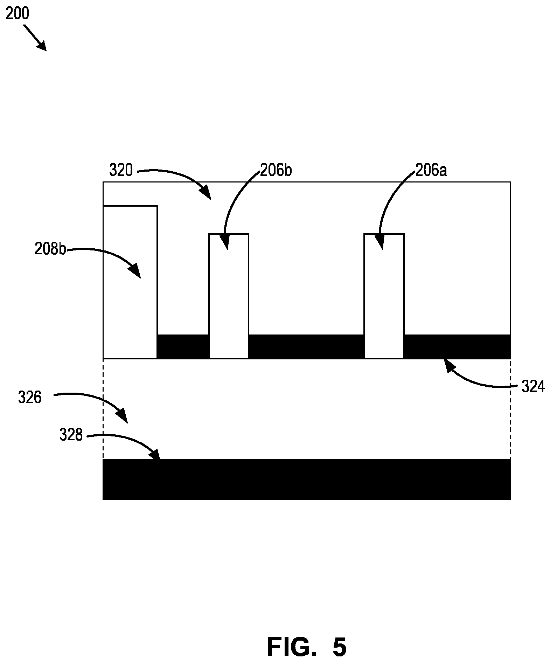

Each heat sink 206 also provides a separate thermal pathway to the substrate 328 underlying the absorber 202. As can be seen in FIG. 2, each heat sink 206 only partially overlies the corresponding lateral protrusion 204. Each heat sink 206 includes a first heat sink portion 216 and a second heat sink portion 218. The first heat sink portion 216 of each heat sink 206 overlies the corresponding protrusion 204. The second heat sink portion 218 of each heat sink 206 does not overlie the corresponding protrusion 204. This enables the heat sink 206 to provide a thermal pathway to the substrate 328 that bypasses the absorber 202. For example, at least a portion of the thermal pathway between the heat sink 206 and the substrate 328 may pass solely through one or more intermediary layers (and not the absorber 202) as shown in FIGS. 4 and 5.

As shown in FIG. 2, each heat sink 206 has a length 206/ extending in the lateral direction 232 and a width 206w extending in the longitudinal direction 230. The width 206w of each of the one or more heat sinks 206 can be substantially greater than a width 204w of the corresponding lateral protrusion 204. Accordingly, the second heat sink portion 218 can extend beyond the corresponding lateral protrusion 204 in the longitudinal direction 230 (to one or both sides of the protrusion 204).

For example, the width 206w of each of the one or more heat sinks 206 may be in the range of about 1 µm to about 10 µm. Optionally, the width 206w of each of the one or more heat sinks 206 may be in the range of about 1 µm to about 5 µm.

For example, the length 206/ of each of the one or more heat sinks 206 may be in the range of about 2 µm to about 20 µm. Optionally, the length 206/ of each of the one or more heat sinks 206 may be in the range of about 4 µm to about 10 µm.

The heat sink aspect ratio of the length 206/ to the width 206w of each heat sink 206 may be selected based on the space available for the heat sink material. For example, the TES 200 may have more space available in the lateral direction 232 than in the longitudinal direction 230 (e.g., due to the leads 208). Accordingly, the heat sink aspect ratio can be defined to be greater than 1:1. Optionally, the heat sink aspect ratio can be defined to be greater than 2:1 to further optimize the space utilization for the TES 200.

In some implementations, the length 206/ and/or width 206w of the heat sinks 206 may vary depending on the number of heat sinks 206 being used. For example, the length 206/ and/or width 206*w* of the heat sinks 206 may be varied to provide a desired total volume for the heat sink material with different numbers of heat sinks 206.

The first heat sink portion 216 can have an area that is at least 5% of the area of the second heat sink portion 218. Optionally, the first heat sink portion 216 may have an area that is equal to or less than the area of the second heat sink portion 218. In some examples, the first heat sink portion 216 may have an area that is equal to or less than 50% of the area of the second heat sink portion 218. Alternatively, the first heat sink portion 216 may be larger than the second heat sink portion 218.

The second heat sink portion 218 can also have an area that is at least 5% of the area of the first heat sink portion 216.

The volume of heat sink material can be defined to provide a desired level of heat dissipation through each heat sink 206 while retaining sufficient energy resolution in the central absorber portion 205. The total volume of the heat sinks 206a-206d can be in a range of about 2 µm³ to about 30 µm³. For example, the total volume of the heat sinks 206a-206d may be in a range of about 5 µm³ to about 20 µm³. In some examples, the total volume of the heat sinks 206a-206d may be in a range of about 5 µm³ to about 15 µm³. Further optionally, the total volume of the heat sinks 206a-206d may be in a range of about 8 µm³ to about 12 µm³.

The volume of the heat sinks 206 may also vary depending on the size of the central absorber portion 205. As the size of the central absorber portion 205 is increased, the heat capacity of absorber 202 increases which thus increases the time required to dissipate energy from an incident photon. Increasing the volume of the heat sinks 206 can compensate for the increase in heat capacity of the absorber 202. For example, for a central absorber portion 205 of about 20 µm by about 20 µm, the total volume of the heat sinks 206 may be in a range from about 8 µm³ to about 12 µm³. Optionally, the total volume of the heat sinks 206 may be about 10 µm³.

Preferably, each heat sink 206 may have the same dimensions (i.e., length 206*l*, width 206w, and depth/thickness) and thus the volume of each individual heat sink 206 can be the same. For example, each heat sink 206 may have a volume of about 2.5 µm³ providing a total volume of 10 µm³ for the TES 200.

Alternatively, the heat sinks 206 may have different dimensions (e.g., different lengths, widths, and/or depths). Optionally, the individual heat sinks 206 may be provided using different volumes of heat sink material.

As illustrated, the heat sink(s) 206 can be spaced apart from the central portion 205. The offset distance 204o between the heat sink(s) and the central portion 205 can be defined to provide a desired tradeoff between enabling phonons to travel from the central portion 205 to the heat sink 206 without interfering with the main current flowing through the central portion 205. The offset distance can be in a range between about 1 µm to about 4 µm. For example, the offset distance can be provided in a range between about 1 µm to about 3 µm. In some examples, the inventors have found that an offset distance 204*o* of about 2.5 µm may be preferable for some applications.

The offset distance may be defined, in part, based on the length 205/ of the central portion 205. The offset distance 204o can be defined to be within a range of about 1% to about 40% of the length 205/. For example, the offset distance 204o may be defined to be in a range of about 3% to about 21% of the length 205/. Further optionally, the offset distance 204o may be defined to be in a range of about 5% to about 15% of the first length or about 5% to about 13% of the first length.

As shown in FIG. 2, the superconducting absorber 202 includes lateral protrusions 204 extending outward from opposing sides of the central portion 205. For instance, protrusions 204a and 204b extend outward from a first side of the central portion 205 while protrusions 204c and 204d extend outward from a second side of the central portion 205. Providing protrusions 204 extending from multiple sides of the central portion 205 may allow for more even heat dissipation across the absorber 202.

An even number of protrusions 204 may also facilitate more even heat dissipation (at least for even-sided central portions 205). For example, the protrusions 204 can be arranged symmetrically about the central portion 205 to facilitate more even heat distribution.

Alternatively, the protrusions 204 may be arranged in an asymmetric configuration. For example, different numbers of protrusions 204 may extend from opposite sides of the central portion 205 and/or the protrusions 204 may be arranged at different positions along the longitudinal direction 230.

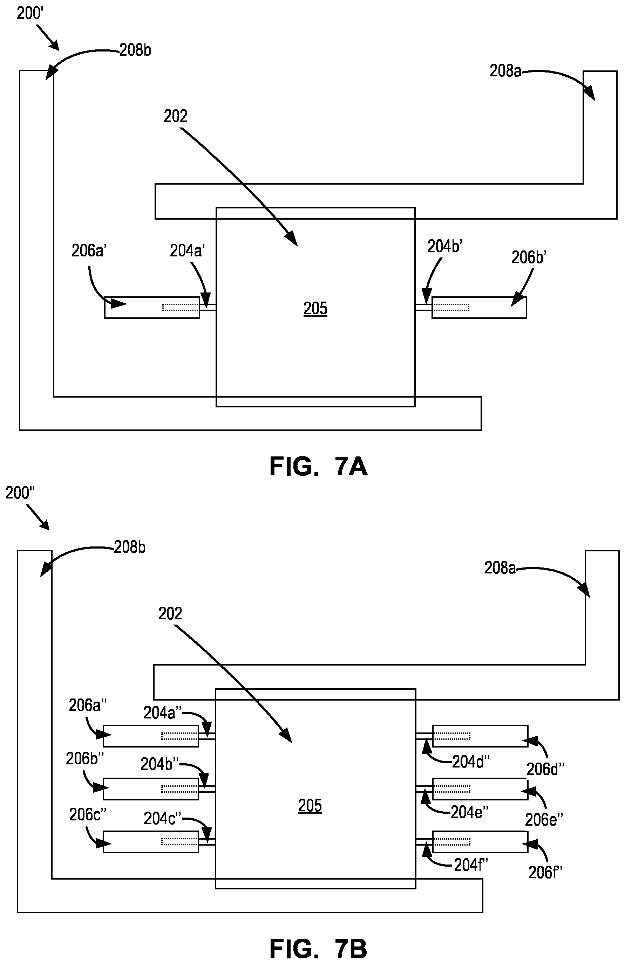

In the example illustrated in FIG. 2, the superconducting absorber 202 includes four lateral protrusions 204a-204d. However, alternative examples may include a lesser number of lateral protrusions (e.g., one lateral protrusion or two lateral protrusions as shown in FIG. 7A) or a greater number of lateral protrusions (e.g., six lateral protrusions as shown in FIG. 7B).

In the example illustrated in FIG. 2, the TES 200 includes four heat sinks 206a-206d. However, alternative examples may include a lesser number of heat sinks (e.g., one heat sinks or two heat sinks as shown in FIG. 7A) or a greater number of heat sinks (e.g., six heat sinks as shown in FIG. 7B). More generally, however, the number of heat sinks 206 is typically equal to the number of lateral protrusions 204.

The superconducting absorber 202 can be coupled to a pair of readout leads 208a and 208b. The readout leads 208 can provide an electrical connection between the absorber 202 and a sensing circuit, such as the example circuit 116 shown in FIG. 1. That is, the readout leads 208 can be used to integrate the TES 200 into an energy sensor system such as the example system 100. In operation, the superconducting absorber 202 can be maintained at the edge of a phase transition to a transition temperature through Joule heating caused by applying a bias current through the readout leads 208.

The substrate 328 may be provided using a bulk wafer material such as silicon or sapphire for example. The substrate 328 has a thickness that is typically in the range of about a few hundred µm to about 1 mm. In operation, the substrate 328 may be maintained at a temperature substantially below the transition temperature of the superconducting absorber 202 to ensure that heat is dissipated to the substrate 328 following absorption of a photon. The substrate 328 can thus function as a phonon bath that eventually absorbs the energy of a photon incident on the absorber 202 and enables the absorber 202 to return to its operating temperature.

The superconducting absorber 202 can be provided using a low-heat-capacity superconducting material such as one or more of tungsten, hafnium, molybdenum, titanium, titanium nitride, bismuth, and aluminum, for example. The absorber material can be selected to provide a weak thermal link between the electron and phonon subsystems of the absorber 202. A weak thermal link can ensure that measurement of the energy of the incident radiation is complete before the absorber 202 returns to its operating temperature.

Optionally, the superconducting absorber 202 may be provided using a single layer of superconducting material. Alternatively, the superconducting absorber 202 can be provided by a bilayer including a superconducting metal and a standard conducting metal.

The heat sinks 206 can be provided using normal conductive metals. The heat sink material can be selected to provide a desired thermal conductance and heat capacity such that it dissipates the energy of the incident photon sufficiently quickly without impacting the resolution of TES 200. The heat sink material may also be selected to enable the heat sink 206 to be deposited onto the protrusions 204 during the fabrication process for the TES 200. For example, gold may be used for the heat sinks.

As can be seen in FIG. 3, the superconducting absorber 202 is arranged to overlie the substrate 328. A plurality of intermediary layers can be provided between the absorber 202 and substrate 328. The thermal pathway between the absorber 202 and the substrate 328 can pass through the plurality of intermediary layers.

The intermediary layers are generally fabricated onto the substrate 328 layer. For example, the intermediary layers can be provided by thin film layers deposited onto substrate 328. The thickness of the individual intermediary film layers is typically about 2 µm or less. The total thickness of the plurality of intermediary layers is typically in a range of about 1 µm to about 10 µm.

The intermediary layers can include at least one of an amorphous silicon layer, an SiO₂ layer, a backside mirror layer, and a dielectric material layer. In the example shown in FIG. 3, the intermediary layers include an amorphous silicon layer 324 and a plurality of stacked layers 326.

The plurality of stacked layers 326 can also include one or more reflective layers. Optionally, the stacked layers 326 may include a plurality of reflective layers arranged to function as a distributed Bragg reflector (DBR). For example, alternating layers of silicon oxide (SiO₂) and amorphous silicon (a-Si) may be provided to operate as a DBR. The specific number and thickness value of the layers can be varied based on the desired reflectance for the DBR and the optical coefficients of the materials selected. Providing a plurality of reflective layers arranged into a DBR can reduce the lossiness of the reflective layers.

Alternatively, the one or more reflective layers can be provided by a metallic reflecting mirror.

The plurality of stacked layers 326 can also be arranged to space the substrate 328 from the absorber 202. Optionally, a specific spacer layer may be provided to ensure the desired spacing between the substrate 328 and the absorber 202. Alternatively, the spacer layer may be provided as part of one or more reflective layers.

As shown in FIG. 3, the central absorber portion 205 has a receiving surface 323 arranged to receive an incident pulse of light. Optionally, one or more outer layers may be provided overlying the receiving surface 323. For example, as shown in FIG. 3, a layer 322 of amorphous silicon may be provided to overlie the central absorber portion 205. The trilayer structure of the amorphous silicon layers 322 and 324 overlying and underlying the absorber 202 may help stabilize the absorber 202.

As shown in FIG. 3, an anti-reflection coating layer 320 can also be provided overlying the receiving surface 323 (as well as the other components of the TES 200). For example, a layer of amorphous silicon and SiO₂ can be used to provide the anti-reflection coating layer 320.

In the example shown in FIGS. 4 and 5, the intermediary layers between the second portion 218 of each heat sink 206 and the substrate 328 are different from the intermediary layers between the absorber 202 and the substrate 328. That is, the amorphous silicon layer 322 is not present between the second portion 218 and the substrate 328. This may facilitate fabrication of the TES 200.

For example, the trilayer structure of the TES 200 can first be defined lithographically. The top layer 322 of amorphous silicon (and a portion of the absorber material) can then be etched using an ion gun to define the central portion 205 and protrusion(s) 204 of the absorber 202. An acid etching process can then remove any remaining exposed absorber material leaving the lower layer 324 of a-Si intact.

A liftoff process can then be used to define and deposit the readout material (e.g., niobium) for readouts 208a and 208b. This process involves an ion mill at the locations where the readout material is to be adhered. This ensures that the readout material contacts the absorber 202 directly (i.e., without an intervening portion of layer 322). The readout material can then be deposited.

A similar process can be used to deposit the heat sink material. Since only the first portion 216 of the heat sink material overlies the absorber 202, the remaining second portion 218 of the heat sink material overlies a region where the lower layer 324 of a-Si has been etched by the ion mill process.

Alternatively, the intermediary layers between the second portion 218 and the substrate 328 may be the same as the intermediary layers between the absorber 202 and the substrate 328. For example, use of a fabrication process in which the a-Si layer 324 is not etched during deposition of the leads 208 and heat sinks 206 may provide a TES 200 with consistent intermediary layers for the second portion 218 and absorber 202.

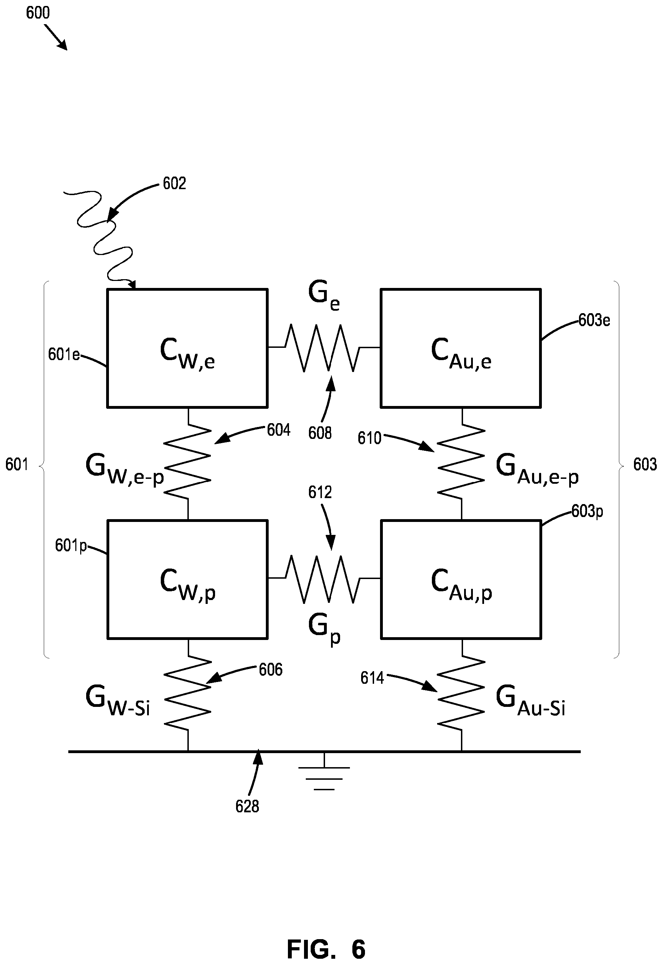

Referring now to FIG. 6, shown therein is a simplified thermal model 600 of the example transition edge sensor 200 shown in FIGS. 2-5. The simplified thermal model 600 illustrates how the heat sink(s) 206 provide additional thermal pathways for the phonons in the absorber 202 to travel to the substrate 328.

When a photon 602 is absorbed by a superconducting absorber 601 (e.g., the central portion 205 of absorber 202), it generates heat in the electron subsystem in the form of excited electrons. The superconducting absorber 601 thus receives a deposition of thermal energy from the electromagnetic radiation (i.e., the photon). The deposition of thermal energy from the photon includes a first set of excited electrons 601e.

This first set of excited electrons 601e then shares its energy across the electron lattice of the sensor. Within the superconducting absorber 601, the coupling 604 from the electron subsystem 601e to the phonon subsystem 601p is weak. As a result, the absorber remains in a "hot" state (i.e., above its operating temperature) for a longer period of time. The coupling between the electron subsystem of the absorber and the phonon subsystem of the substrate 628 can ensure that the TES is capable of measuring the incident energy from an absorbed photon before being cooled to its operating temperature while ensuring that the recovery time is sufficiently low to enable the TES to operate at a high throughput rate.

As shown in FIG. 6, a first portion of the thermal energy from the photon 602 can be transferred to the substrate 628 through a first thermal pathway. The first thermal pathway includes a first thermal coupling 604 and a second thermal coupling 606.

The first portion of the thermal energy is transferred to a first set of phonons 601p in the superconducting absorber 601 by the first thermal coupling 604. In the example of TES 200, this first thermal coupling 604 is provided by the coupling between the electron subsystem 601e and the phonon subsystem 601p of the absorber 202.

The first set of phonons can then be transferred to phonons in the substrate 628 by way of a second thermal coupling 606. In the example of TES 200, this second thermal coupling 606 is provided by the thermal transfer path between the absorber 202 and substrate 328.

The heat sink(s) connected to the protrusions 204 provide additional pathways to dissipate the thermal energy absorbed by the absorber 202. The heat sink material establishes a short circuit between the electrons 601e in the superconducting absorber 601 and the phonons 603p in the heat sink material. Phonon to phonon coupling between the heat sink material, superconducting absorber, and substrate 628 can then occur rapidly, reducing the time required to dissipate the thermal energy absorbed by absorber 202.

As shown in FIG. 6, a second portion of the thermal energy from the photon 602 absorbed by the absorber 601 can be transferred to the substrate by a second thermal pathway that includes a third thermal coupling 608, fourth thermal coupling 610, and fifth thermal coupling 612. The second portion of the thermal energy can be transferred to a second set of excited electrons 603e in the one or more heat sinks by way of the third thermal coupling 608. In the example of TES 200, this third thermal coupling 608 is provided by the coupling between the electron subsystem 601e of the protrusion(s) 204 and the electron subsystem 603e of the corresponding heat sink(s) 206 in contact with the protrusion(s) 204.

The second set of excited electrons 603e can then be converted to a second set of phonons 603p in the one or more heat sinks by way of the fourth thermal coupling 610. In the example of TES 200, this fourth thermal coupling 610 is provided by the coupling between the electron subsystem 603e and the phonon subsystem 603p of the heat sink(s) 206. The heat sink(s) 206 can be selected to have a stronger coupling between the electron and phonon subsystems (as compared to the weak electron-phonon coupling of the superconducting absorber material).

The second set of phonons 603p can then be converted to a third set of phonons 601p in the superconducting absorber 601 by way of a fifth thermal coupling 612. In the example of TES 200, this fifth thermal coupling 612 is provided by the coupling between the phonon subsystem 601p of the protrusion(s) 204 and the phonon subsystem 603p of the corresponding heat sink(s) 206 in contact with the protrusion(s) 204.

The third set of phonons can then be transferred to phonons in the substrate 628 by way of the second thermal coupling 606.

As noted above, the heat sinks 206 also provide a separate thermal pathway to the substrate that bypasses the absorber 202. As shown in FIG. 6, a third portion of the thermal energy from the photon 602 absorbed by the absorber 601 can be transferred to the substrate by a third thermal pathway that includes a third thermal coupling 608, fourth thermal coupling 610, and sixth thermal coupling 614.

Similar to the second thermal pathway, the third portion of the thermal energy can be transferred to a third set of excited electrons 603e in the one or more heat sinks by way of the third thermal coupling 608. The third set of excited electrons can then be converted to a fourth set of phonons in the one or more heat sinks 603p by way of a fourth thermal coupling 610.

The fourth set of phonons can then be transferred to phonons in the substrate 628 by way of the sixth thermal coupling 614. In the example of TES 200, this sixth thermal coupling 614 is provided by the heat sink thermal transfer path between the second portion 218 of the heat sink(s) 206 and the substrate 328. The heat sink thermal transfer path bypasses the absorber 202 to transfer the fourth set of phonons directly to the substrate 328.

While the above description provides examples of one or more processes or apparatuses or systems, it will be appreciated that other processes or apparatuses or systems may be within the scope of the accompanying claims.

It will be understood that the embodiments described in this disclosure and the module, routine, process, thread, or other software component implementing the described methods/processes/frameworks may be realized using standard computer programming techniques and languages. The present application is not limited to particular processors, computer languages, computer programming conventions, data structures, and/or other such implementation details. Those skilled in the art will recognize that the described methods/processes may be implemented as a part of computer-executable code stored in volatile or non-volatile memory, as part of an application-specific integrated chip (ASIC), etc.

As will be apparent to a person of skill in the art, certain adaptations and modifications of the described methods/processes/frameworks can be made, and the above discussed embodiments should be considered to be illustrative and not restrictive.

To the extent any amendments, characterizations, or other assertions previously made (in this or in any related patent applications or patents, including any parent, sibling, or child) with respect to any art, prior or otherwise, could be construed as a disclaimer of any subject matter supported by the present disclosure of this application, Applicant hereby rescinds and retracts such disclaimer. Applicant also respectfully submits that any prior art previously considered in any related patent applications or patents, including any parent, sibling, or child, may need to be re-visited.

## Claims

1. A transition edge sensor (TES) comprising:
a substrate;
a superconducting absorber having one or more lateral protrusions, wherein an absorber thermal pathway thermally couples the superconducting absorber to the substrate; and
one or more heat sinks,
wherein each of the one or more heat sinks is (1) in thermal contact with the substrate via a heat sink thermal pathway and (2) overlies a lateral protrusion of the one or more lateral protrusions.

2. The TES of claim 1, wherein the one or more heat sinks comprises at least two heat sinks, each of the at least two heat sinks being partially in contact with the one or more lateral protrusions; and
optionally the at least two heat sinks comprises at least four heat sinks.

3. The TES of any one of claims 1 to 2, further comprising one or more intermediary layers, wherein the absorber thermal pathway between the superconducting absorber and the substrate extends through the one or more intermediary layers;
wherein
optionally each layer of the one or more intermediary layers comprises at least one of amorphous silicon, SiO₂, a backside mirror, or a dielectric material; and
further optionally a subset of the one or more intermediary layers defines a distributed Bragg reflector.

4. The TES of any one of claims 1 to 3, wherein the heat sink thermal pathway between each heat sink and the substrate at least partially bypasses the superconducting absorber.

5. The TES of any one of claims 1 to 4, wherein each heat sink comprises at least a first heat sink portion and a second heat sink portion, wherein for each heat sink the first heat sink portion overlies the corresponding lateral protrusion, and the second heat sink portion overlies solely one or more of intermediary layers between the superconducting absorber and the substrate.

6. The TES of claim 5, wherein
the one or more protrusions extend outward from the superconducting absorber along a lateral direction and the second heat sink portion extends outward from the first heat sink portion along a longitudinal direction perpendicular to the lateral direction; and/or.
the one or more protrusions extend outward from the superconducting absorber along a lateral direction and the second heat sink portion extends outward from the first heat sink portion along the lateral direction.

7. The TES of any one of claims 5 to 6, wherein the superconducting absorber, the one or more lateral protrusions, and the second heat sink portion of each heat sink are in direct contact with at least some of the intermediary layers and directly overlie the at least some of the intermediary layers.

8. The TES of any one of claims 1 to 7, wherein the superconducting absorber has a central portion, the lateral protrusions extend outward from the central portion along a lateral direction, and the central portion has a length of at least 15 µm in the lateral direction and a width of at least 15 µm in a longitudinal direction.

9. The TES of any one of claims 1 to 8, wherein:
the superconducting absorber has a central portion, the lateral protrusions extend outward from the central portion along a lateral direction, and the central portion has a first width extending along a longitudinal direction perpendicular to the lateral direction;
each lateral protrusion has a second width in the longitudinal direction; and
the first width is substantially greater than the second width;
optionally, the second width is in a range of about 0.5% to about 30% of the first width; and
preferably, the second width is defined to maintain a superconducting order parameter of the superconducting absorber that exists in the absence of the lateral protrusions.

10. The TES of any one of claims 1 to 9, wherein:
the superconducting absorber has a central portion;
the lateral protrusions extend outward from the central portion along a lateral direction; and
each heat sink is spaced apart from the central portion by a first distance along the lateral direction; and
optionally the central portion has a first length extending along the lateral direction and the first distance is in a range of about 1% to about 40% of the first length.

11. An energy sensor system comprising:
a transition energy sensor (TES) comprising:
a substrate;
a superconducting absorber having one or more lateral protrusions, wherein an absorber thermal pathway thermally couples the superconducting absorber to the substrate; and
one or more heat sinks;
wherein each of the one or more heat sinks is (1) in thermal contact with the substrate via a heat sink thermal pathway and (2) overlies a lateral protrusion of the one or more lateral protrusions;
an inductor connected in series with the TES; and
a magnetometer inductively coupled with the inductor.

12. The energy sensor system of claim 11, wherein the TES comprises:
a substrate;
a superconducting absorber having one or more lateral protrusions, wherein an absorber thermal pathway thermally couples the superconducting absorber to the substrate; and
at least two heat sinks, each of the at least two heat sinks being partially in contact with the one or more lateral protrusions.
wherein each of the heat sinks is in thermal contact with the substrate via a heat sink thermal pathway.

13. The energy sensor system of any one of claims 11 and 12, further comprising at least one readout lead coupling the TES to the inductor.

14. The energy sensor system of any one of claims 11 to 13, wherein the energy sensor is configured to measure a change in current through the TES in response to a photon being deposited on the TES.

15. The energy sensor system of any one of claims 11 to 14, wherein the magnetometer is configured to detect a change in current through the TES in response to a photon being deposited on the TES.
